# EUROPEAN PATENT APPLICATION

(11) **EP 2 230 688 A1**
(43) Date of publication of application: **22.09.2010**
(21) Application number: 09155702.5
(22) Date of filing: 20.03.2009
(51) Int. Cl.: H01L 23/538, H01L 23/31

(54) **Fan out semiconductor package and manufacturing method**

(71) Applicant: NXP B.V., 5656 AG Eindhoven (NL)
(72) Inventor: Pommier, Mickael, Redhill Surrey RH1 1DL (GB); Rousseville, Lucie A., Redhill Surrey RH1 1DL (GB); Ledain, Sophie, Redhill Surrey RH1 1DL (GB)
(74) Representative: Williamson, Paul Lewis

(57) **Abstract**

Disclosed is a semiconductor package (100) comprising a semiconductor die (120) having a plurality of die contacts (122), a plurality of external contacts (140), said external contacts being distributed over an area larger than the die area, and a contact redistribution layer (130) for fanning out the die contacts to the external contacts, the semiconductor die being covered in a protective resin (110), wherein the edge (124) of the semiconductor die (120) facing the contact redistribution layer (130) is shaped such that the package comprises a resin-filled indentation between the semiconductor die (120) and the contact redistribution layer (130). A method of manufacturing such a package is also disclosed.

## Description

### FIELD OF THE INVENTION

The present invention relates to a semiconductor package comprising a semiconductor die having a plurality of die contacts, a plurality of external contacts, said external contacts being distributed over an area larger than the die area, and a contact layer for fanning out the die contacts to the external contacts, the semiconductor die being embedded in a protective resin.

The present invention further relates to a method of manufacturing such a package.

### BACKGROUND OF THE INVENTION

In the field of semiconductor packaging, wafer-level packaging has been attracting considerable interest. In wafer-level packaging, individual dies are packaged whilst still forming an integral part of their native wafer, such that only a few packaging steps are required to package all individual dies. The wafer is cut into individual dies after packaging, thus reducing the cost of the packaging process.

This approach however has some drawbacks. Firstly, it is likely that a wafer contains some faulty dies, which means that when packaging all dies on a single wafer, such faulty dies are also packaged. Not only does this lead to the unnecessary packaging of dies to be rejected, but it can complicate the identification of the faulty dies in cases where it is more difficult to test the die following its packaging. Secondly, providing external contacts on the package may prove difficult, especially with the decreasing area of semiconductor dies.

These drawbacks have led to the development of so-called fan-out wafer level chip scale packages. An example of such a package is given in US 6,462,274 B1. Such packages are characterized by the presence of a contact, i.e. redistribution, layer between the contacts, e.g. pads, of the packaged die and the external contacts, i.e. the contacts on the outside, of the package, wherein the external contacts are distributed over an area extending beyond the area of the die. A typical manufacturing method of such a package contains testing the dies whilst still on their native wafer, after which the wafer is cut and only the dies that passed testing are redistributed on a further carrier such as an adhesive layer or some other substrate, where the dies are covered in a protective resin, followed by the removal of the substrate and subsequent formation of the redistribution layer and external contacts, e.g. by soldering, after which the packages are separated from each other.

Such fan-out packages are not without problems. For instance, it has been found that some packages suffer from redistribution layer failure during their lifetime, which is highly unwanted because such a failure invariably leads to the perceived failure of the electronic device into which the package has been integrated.

### SUMMARY OF THE INVENTION

The present invention seeks to provide a fan-out semiconductor package having a more robust contact layer.

The present invention further seeks to provide a method of manufacturing a fan-out semiconductor package having a more robust contact layer.

According to a first aspect of the present invention, there is provided a semiconductor package comprising a semiconductor die having a plurality of die contacts, a plurality of external contacts, said external contacts being distributed over an area larger than the die area, and a contact layer for fanning out the die contacts to the external contacts, the semiconductor die being covered in a protective resin, wherein the edge of the semiconductor die facing the contact redistribution layer is shaped such that the package comprises a resin-filled indentation between the semiconductor die and the contact redistribution layer.

It has surprisingly been found that the damage to the contact redistribution layer is caused by thermal friction between the die and the protective resin in such packages. This friction is caused by the different thermal expansion coefficients of the die material, e.g. silicon, and the protective resin, e.g. an epoxy resin. Due to the fact that the semiconductor die package is typically exposed to significant temperature variations during its lifetime, e.g. from -10°C - 50°C, the stresses caused by the different expansion of the resin and the semiconductor material can cause cracking of the contact redistribution layer. These stresses can be reduced by changing the shape of the semiconductor die side walls such that a rein-filled recess or indentation is present between a portion of the semiconductor die and the contact redistribution layer. Such an edge may have any suitable shape. For instance, the edge may be chamfered, or may be rounded instead.

It will be appreciated that the present invention is not limited to fan-out packages containing a single die only. In an embodiment, the package comprises a plurality of said dies, wherein the plurality of external contacts comprises a plurality of sets of contacts, each set corresponding to a respective one of said dies, wherein the external contacts of each set are distributed over an area larger than its corresponding die. In other words, each die in the package has fanned out external contacts.

In a further embodiment, the package comprises an interface layer between the external contacts and the contact layer, said interface layer comprising contact portions for contacting the external contacts to the contact layer. Such contact portions can improve the quality of the connection of the external contacts, e.g. solder balls, to the contact redistribution layer.

The semiconductor package of the present invention may be integrated in an electronic device such as a mobile communications device. Such an electronic device benefits from the improved reliability of the semiconductor package of the present invention.

According to another aspect of the present invention, there is provided a method of manufacturing a semiconductor package, comprising providing a wafer comprising a plurality semiconductor dies, each semiconductor die having a plurality of die contacts; shaping an edge of said dies such that when placing said die on a further carrier, an indentation exists between said die and the further carrier; separating the individual semiconductor dies of said wafer; placing a plurality of known good dies on the further carrier such that said respective edges contact the further carrier; embedding the plurality of known good dies in a protective resin mold, thereby filling said indentations with the protective resin; replacing the further carrier with a patterned contact redistribution layer on the die contacts of the plurality of known good dies exposed by the removal of the further carrier layer, said contact redistribution layer fanning out the die contacts of the respective known good dies; forming external contacts on the contact redistribution layer; and forming respective semiconductor packages by cutting said mold.

This has the advantage of providing fan-out packages having an improved contact redistribution layer reliability for the reasons already explained.

The edge of the semiconductor dies may be formed in any suitable way. Preferably, the edge is formed by chamfered sawing of the wafer. The edge may have a rounded shape by continuously altering the cutting angle of the wafer. Alternatively, step of separating the individual dies may comprise two sub-steps, in which the edge formation step may be an etching step followed by sawing of the wafer.

### BRIEF DESCRIPTION OF THE EMBODIMENTS

Embodiments of the invention are described in more detail and by way of non-limiting examples with reference to the accompanying drawings, wherein
FIG. 1 schematically depicts a fan-out package;
FIG. 2 shows a detail of a fan-out package;
FIG. 3 schematically depicts a known fan-out package;
FIG. 4 schematically depicts a fan-out package in accordance with an embodiment of the present invention;
FIG. 5 shows a detail of the fan-out package of FIG.4; and
FIG. 6 schematically depicts an embodiment of the method of the present invention.

### DETAILED DESCRIPTION OF THE DRAWINGS

It should be understood that the Figures are merely schematic and are not drawn to scale. It should also be understood that the same reference numerals are used throughout the Figures to indicate the same or similar parts.

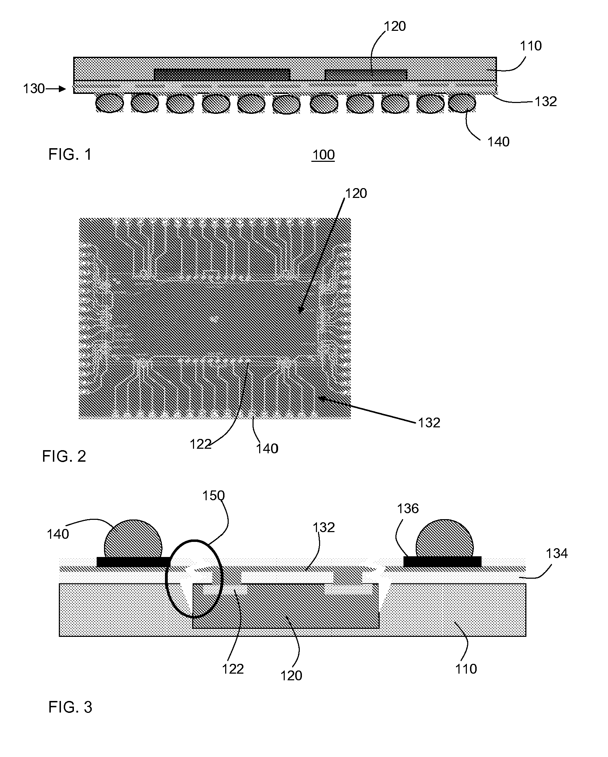

FIG. 1 shows a fan-out package 100 comprising a plurality of dies 120 embedded in a protective resin 110. The active regions comprising the contacts of the dies 120 are connected to a contact redistribution layer 130 (from hereon referred to as redistribution layer), which contains conductive tracks 132 such as copper tracks. The conductive tracks 132 typically extend through an insulating medium from the die contacts to external contacts 140, e.g. solder balls. In a fan-out package, the external contacts 140 cover a larger area, i.e. have a larger foot print, than the die contacts to which they are connected. This is demonstrated in more detail in FIG. 2, in which the die contacts 122 are spread over a larger area by the external contacts 140 via the conductive tracks 132 in the redistribution layer 130.

Such packages are known per se, and may be manufactured in any suitable way. Also, although the fan-out package 100 is shown to contain more than one semiconductor die 120, it should be understood that a fan-out package containing a single semiconductor die is equally feasible.

The fan-out package of Fig. 1 can suffer from failure of the redistribution layer 130 during the lifetime of the package. It has surprisingly been found that this failure is not caused by structural integrity problems of the redistribution layer 130 but from stresses projected onto the redistribution layer 130 from the boundary between the protective resin 110 and the semiconductor die 120. This is demonstrated in Fig. 3. In Fig. 3, the external contacts 140 are connected to the conductive tracks 132 of the redistribution layer 130 via under bump metallurgy portions 136. Such portions are well-known and are used to improve the contact quality between the conductive tracks 132 and the external contacts 140, in particular when solder balls are used for the external contacts 140, where the portions 136 provide an anchor for the solder.

However, due to the fact that the thermal expansion coefficient of the protective resin 110, e.g. an epoxy resin, is substantially different to the thermal expansion coefficient of the semiconductor material, e.g. silicon, used in the semiconductor die 120, exposure of the package 100 to varying temperatures causes the interface between the protective resin 110 and the semiconductor die 120 to experience stress forces. This can cause warping of the fan-out package 100, such that the redistribution layer 130 cracks, thereby severing the conductive patterns 132, as shown in region 150. It is pointed out that the insight that the damage to the redistribution layer 130 caused by a problem unrelated to the structural composition of the redistribution layer 130 has not been previously reported to the best of the applicant's knowledge.

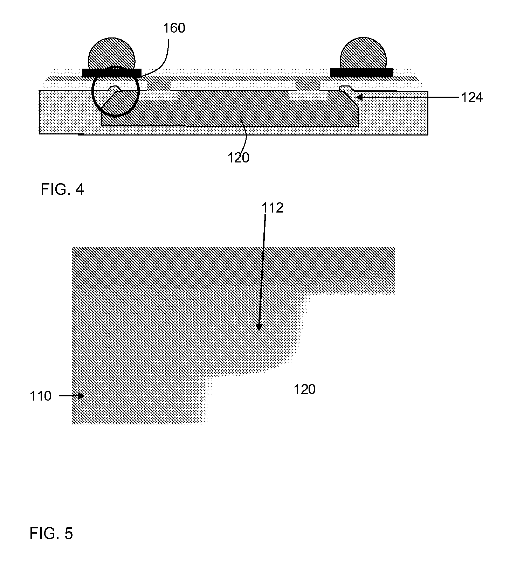

It has been realized that this problem may be solved as shown in FIG. 4. The fan-out package shown in FIG. 4 comprises a semiconductor die 120 having side walls 124 that are shaped such that the edge of the semiconductor die 120 in contact with the redistribution layer 130 comprises an indentation or recess 112 of about 10µm in the semiconductor die 120 allowing a good grip between the die 120 and the protective resin 110. Other suitable dimensions of the indentation or recess 112 may be chosen. The dimensions should be such that the indentation is filled with the protective resin 110 during the die molding process.

The shape of the side walls 124 of the semiconductor die 120 may be achieved in any suitable manner. In a preferred embodiment, the side walls 124 are shaped in the wafer sawing process of the wafer from which the semiconductor die 120 originates. Such a shape may for instance be realized by chamfered sawing of this wafer. Chamfering is known per se and will not be explained in further detail for reasons of brevity only. Chamfered sawing may be applied under a constant angle, thus leading to the shape of the side wall 124 as shown in FIG. 4. However, this is by way of non-limiting example only. Other embodiments, such as continuously varying the sawing angle to obtain a rounded profile on the side walls 124, are equally feasible. Other side wall shaping processes, e.g. etching the surface of the wafer, for instance using an anisotropic etch before sawing the wafer, may also be used, although these add additional steps to the fan-out package manufacturing process and are therefore less preferred.

The shaped side walls 124 improve the encapsulation of the semiconductor die 120 in the protective resin 110 as shown in greater detail in FIG. 5. The molding of the semiconductor die 120 in the protective resin 110 causes the formation of a bulge 112 in the protective resin 110 on top of the semiconductor die 120, which improves the quality of the encapsulation and reduces the risk of delamination of the protective resin 110 from the side walls 124 of the semiconductor die 120. In addition, the angled shape of the side walls 124 reduces the bending forces exerted on the redistribution layer 130 as a result of the thermal expansion coefficient mismatch between the protective resin 110 and the semiconductor die 120, such that the redistribution layer 130 is less prone to cracking.

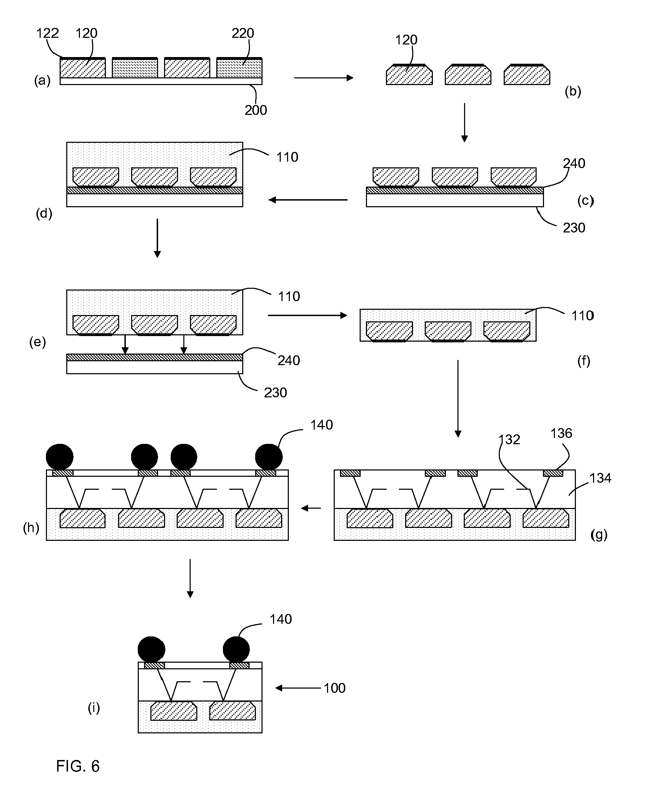

A non-limiting example of a method of manufacturing a fan-out package 100 in accordance with an embodiment of the present invention is shown in FIG. 6. In step (a), a wafer 200 is provided carrying known good dies 120 with an active surface 122 and known faulty dies 220. The determination of whether the dies on the wafer 200 are good or faulty may be achieved in any suitable manner, e.g. by applying suitable wafer test methods. The wafer 200 may for instance comprise test monitors in the scribe lines of the wafer 200 and so on. In step (b), the wafer 200 is cut to yield individual semiconductor dies 120 and 220. The cutting preferably takes place by chamfered sawing of the wafer 200 to yield semiconductor dies with angled side walls to form an indentation 112, as previously explained.

In step (c), the known good dies 120 are redistributed on a further carrier, such as a substrate 230 carrying a double-sided adhesive tape 240 such as a Nitto-Revalpha 3195V tape. The surface comprising the contacts 122 of the known good dies 120 are placed on this adhesive substrate. It is emphasized that other redistribution techniques, e.g. using substrates comprising pre-shaped recesses for receiving the known good dies 120, are equally feasible. In step (d), the protective resin 110 is molded over the further carrier such that the known good dies 120 are embedded in the resin 110. Any suitable resin may be used, such as an epoxy resin. Preferably, a resin is selected for which the difference in thermal expansion coefficient with the semiconductor material is as small as possible.

In step (e), the further carrier is removed from the known good dies 120 embedded in the protective resin 110, after a grinding step (f) is applied to the protective resin 110 to reduce its thickness. In step (g), the redistribution layer 130 is formed on the exposed contacts 122 of the known good dies 120. This may be achieved in any suitable manner. For instance, the conductive tracks 132 may be formed on the contacts 122 and embedded in an electrically insulating layer 134, after which the under bump metallurgy portions 136 are formed on the conductive tracks 132. In step (h), the external contacts 140 are formed, e.g. by soldering, on the portions 136, after which the individual fan-out packages 100 are formed in step (i), e.g. by sawing the mold formed by the protective resin 110.

It should be apparent that the inventive contribution to the method of FIG. 6 resides in step (b), i.e. the provision of the semiconductor dies 120 having shaped side walls 124, and that this step may be combined with any suitable process for obtaining a fan-out package 100.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A semiconductor package (100) comprising a semiconductor die (120) having a plurality of die contacts (122), a plurality of external contacts (140), said external contacts being distributed over an area larger than the die area, and a contact redistribution layer (130) for fanning out the die contacts to the external contacts, the semiconductor die being covered in a protective resin (110), wherein the edge (124) of the semiconductor die (120) facing the contact redistribution layer (130) is shaped such that the package comprises a resin-filled indentation between the semiconductor die (120) and the contact redistribution layer (130).

2. The package (100) of claim 1, wherein said edge is chamfered.

3. The package (100) of claim 1, wherein said edge is rounded.

4. The package (100) of any of claims 1-3, wherein the package comprises a plurality of said dies (120), wherein the plurality of external contacts (140) comprise a plurality of sets of contacts, each set corresponding to a respective one of said dies, wherein the external contacts of each set are distributed over an area larger than its corresponding die.

5. The package (100) of any of claims 1-4, further comprising an interface layer between the external contacts and the contact redistribution layer (130), said interface layer comprising contact portions (136) for contacting the external contacts (140) to the contact redistribution layer.

6. The package (100) of any of claims 1-5, wherein the resin is an epoxy resin.

7. An electronic device comprising a semiconductor package (100) according to any of claims 1-6.

8. A method of manufacturing a semiconductor package (100), comprising:
providing a wafer (200) comprising a plurality semiconductor dies (120, 220), each semiconductor die having a plurality of die contacts (122);
shaping an edge (124) of the semiconductor dies (120) such that when placing said die on a further carrier, an indentation exists between the semiconductor die and the further carrier;
separating the individual semiconductor dies (120, 220) of said wafer;
placing a plurality of known good dies (120) on the further carrier such that said respective edges contact the further carrier;
embedding the plurality of known good dies in a protective resin mold (110), thereby filling said indentations with the protective resin;
replacing the further carrier with a patterned contact redistribution layer (130) on the die contacts of the plurality of known good dies (120) exposed by the removal of the further carrier layer, said contact redistribution layer (130) fanning out the die contacts of the respective known good dies;
forming external contacts (140) on the contact redistribution layer (130); and
forming respective semiconductor packages (100) by cutting said mold (110).

9. The method of claim 8, wherein separating the known good dies comprises forming a die package comprising more than one known good die.

10. The method of claim 8 or 9, wherein the edge is shaped whilst separating the individual semiconductor dies (120, 220).

11. The method of claim 10, wherein said edge (124) is formed by chamfered cutting of the wafer (200).

12. The method of claim 11, wherein said edge (124) is a rounded edge formed by continuously altering the cutting angle of the wafer (200).

13. The method of claim 8 or 9, wherein said edge (124) is formed by an etching step.
